# EUROPEAN PATENT SPECIFICATION

(11) **EP 2 780 648 B1**
(45) Date of publication and mention of the grant of the patent: **24.06.2020**
(21) Application number: 12794817.2
(22) Date of filing: 12.11.2012
(51) Int. Cl.: F25B 23/00, F24F 11/00, H05K 7/20

(54) **HYBRID REFRIGERANT CIRCULATING COOLING SYSTEM**
KÜHLSYSTEM MIT HYBRIDKÜHLMITTELZIRKULATION
SYSTÈME DE REFROIDISSEMENT À CIRCULATION DE RÉFRIGÉRANT HYBRIDE

(30) Priority: 15.11.2011 CN 201120451188 U
(43) Date of publication of application: 24.09.2014
(73) Proprietor: Carrier Corporation, Farmington, CT 06034 (US)
(72) Inventor: KUANG, YuHui, Shanghai 200240 (CN); CHIANG, Robert Hong-Leung, Shanghai 20036 (CN); GRABON, Michel, 01360 Bressolles (FR); ZHAO, Lijia Jessica, Shangai 200001 (CN)
(74) Representative: Schmitt-Nilson Schraud Waibel Wohlfrom Patentanwälte Partnerschaft mbB
(86) International application number: PCT/US2012/064620
(87) International publication number: WO 2013/074435

(56) References cited:
- EP-A1- 2 314 956
- WO-A1-2008/127344
- GB-A- 2 258 298
- US-A1- 2011 242 755

## Description

This invention relates to the technical field of refrigeration, and in particular to a hybrid refrigerant circulation cooling system and a data processing center provided with the hybrid refrigerant circulating cooling system.

### BACKGROUND OF THE INVENTION

With the development and improvement of modern scientific technologies, especially with the increasing demands on various transactions in people's daily lives or business activities, a considerable number of application environments for high power and high heat density loads have been arising continuously. For example, with the rapid development of information technologies, when computers, servers or communication base stations, which serve as fundamental facilities for performing various operations such as data access, storage and computing, are equipped in an increasing amount and with increasing powerful functions, the energy consumed by these data devices is also surprisingly large, thus leading to heat dissipation problem calling for attention. Moreover, based on a consideration of scale economies effect, people tend to construct various data storage centers, network service centers, data transfer centers and the like, by grouping a number of computers. Issues involving heat processing and heat safety, etc., caused by these devices residing in such important sites are worth considerable attention and should be well settled.

For the above problems, if a conventional air cooling method is used, a close integration with computer device suppliers may be required, which will not only consume tremendous time and efforts and increase costs, but also makes it still difficult to well suit such operation environments for high power and high heat density loads, as well as brings about plenty of energy consumption in terms of cooling air conveying. In addition, based on safety considerations, a full water cooling system which employs water as refrigerating medium is also not suitable for such an environment. A VRF (Variable Refrigerant Flow) system not only requires the realization of a rather complicated control process, but also necessitates the use of a substantial amount of refrigerant.

EP 2 314 956 A1 discloses a cooling system for transferring heat from a heat load to an environment has a volatile working fluid. The cooling system includes first and second cooling cycles that are thermally connected to the first cooling cycle. The first cooling cycle is not a vapour compression cycle and includes a pump, an air-to-fluid heat exchanger, and a fluid-to-fluid heat exchanger. The second cooling cycle can include a chilled water system for transferring heat from the fluid-to-fluid heat exchanger to the environment. Alternatively, the second cooling system can include a vapor compression system for transferring heat from the fluid-to-fluid heat exchanger to the environment.

GB 2 258 298 A discloses a cooling apparatus which comprises: a primary refrigeration circuit; a secondary heat transfer circuit comprising a secondary condenser cooled by the primary refrigeration circuit; and an evaporator for cooling a desired location; wherein the secondary heat transfer circuit contains a volatile secondary heat transfer fluid which is carbon dioxide, the carbon dioxide being under pressure such that it is liquified in the secondary condenser and evaporates in the secondary evaporator.

WO 2008 127 344 A1 discloses a system and method of reducing consumption of electricity used to cool electronic computer data center, networking, and telecommunications equipment, and to reduce the incidence of thermal failure of electronic components, includes provision of one or more partitions to reduce the volume of the cooled environment supplying coldest possible cooled air from air conditioning systems to a chamber adjacent to racks containing the electronic components, preventing dilution of the supplied cooling airflow by warmer air from outside of the reduced volume environment, and controlling the delivery of cooling air flow through the reduced volume of the cooled environment.

### SUMMARY OF THE INVENTION

Firstly, according to one aspect of the present invention, a hybrid refrigerant circulating cooling system is provided so as to effectively solve the above-mentioned problems and other problems existing in the prior art. The hybrid refrigerant circulating cooling system comprises:
a refrigerant conduit in which refrigerant is disposed; an air conditioner terminal device which is disposed adjacent to an object to be cooled and comprises a heat exchanger and a blower, wherein the heat exchanger communicates with the refrigerant conduit to form a circuit, and the refrigerant flows into the heat exchanger in a liquid phase and flows out of the heat exchanger in a gas-liquid two-phase or in a gas phase, and the blower conveys a working air stream which sequentially contacts with the object to be cooled and the heat exchanger; a cooling device which is disposed downstream of the heat exchanger along the direction in which the refrigerant flows, wherein the refrigerant in the refrigerant conduit downstream of the cooling device is in a liquid phase; and a pumping device which is disposed downstream of the cooling device to pump the refrigerant in a liquid phase into the heat exchanger, wherein the air conditioner terminal device is disposed above the object to be cooled, and the flow path of the working air stream is configured in a substantial U shape such that the working air stream exits from the air conditioner terminal device in a basically vertical direction, enters, passes and leaves the object to be cooled in a basically horizontal direction and enters into the air conditioner terminal device in a basically vertical direction.

In an embodiment of the hybrid refrigerant circulating cooling system according to the present invention, optionally, the hybrid refrigerant circulating cooling system is provided with at least two air conditioner terminal devices, and the working airstreams formed by the respective blowers in the adjacent air conditioner terminal devices have flow paths in which the directions of flow are opposite.

In an embodiment of the hybrid refrigerant circulating cooling system according to the present invention, optionally, the air conditioner terminal device is disposed above the object to be cooled, and the flow path of the working airstream is configured in a substantial U shape.

In an embodiment of the hybrid refrigerant circulating cooling system according to the present invention, optionally, the air conditioner terminal device is configured to have a heat exchanging section and a blower section which can be assembled together in a removable manner, and wherein the heat exchanger and the blower are disposed in the heat exchanging section and the blower section, respectively.

In an embodiment of the hybrid refrigerant circulating cooling system according to the present invention, optionally, the air conditioner terminal device further comprises a controller which is associated with the blower.

In an embodiment of the hybrid refrigerant circulating cooling system according to the present invention, optionally, the cooling device comprises:
a condenser which, by means of cooling water, absorbs heat energy released by the refrigerant; and
a cooling water supplier which serves to store water and supply it to the condenser after the water is cooled.

In an embodiment of the hybrid refrigerant circulating cooling system according to the present invention, optionally, the refrigerant is an oil-free refrigerant, including natural refrigerant such as carbon dioxide, and artificial synthesized refrigerant such as HFC (hydrofluorocarbons).

In an embodiment of the hybrid refrigerant circulating cooling system according to the present invention, optionally, the object to be cooled is the rack of data processing device.

Further, according to another aspect of the present invention, a data processing center comprising at least one data processing device is provided, wherein a hybrid refrigerant circulating cooling system according to any of the above-mentioned systems is disposed in the data processing center to perform cooling treatment.

When the hybrid refrigerant circulating cooling system according to the present invention is employed, a very accurate and efficient "spot cooling", as compared with the prior art, can be performed on each object to be cooled. Therefore, heat dissipation problems involved in operating environments for high power and high heat density loads can be considerably addressed, which facilitates ensuring a long-term stable operation of devices and prolonging their life spans. In particular, by using an oil-free refrigerant such as natural refrigerant like carbon dioxide, or artificial synthesized refrigerant such as HFC (hydro fluorocarbons) as working medium to perform phase transition heat exchange, a risk of potential damage caused by using water cooling and the like to data processing devices can be avoided. Moreover, a close integration with suppliers of such devices is not required, and there is no need to provide some components such as a compressor, an expansion valve. Therefore, this invention provides for excellent flexibility, mobility, reliability and safety. The hybrid refrigerant circulating cooling system according to the present invention possess a number of such advantages as high reliability, excellent scalability and redundancy, and the data processing center provided by the invention can make full use of these advantages so as to address the aforementioned problems that need to be solved.

### BRIEF DESCRIPTION OF THE DRAWINGS

Solutions of the present invention will be further described in detail in conjunction with the following embodiments and accompanying drawings, wherein:

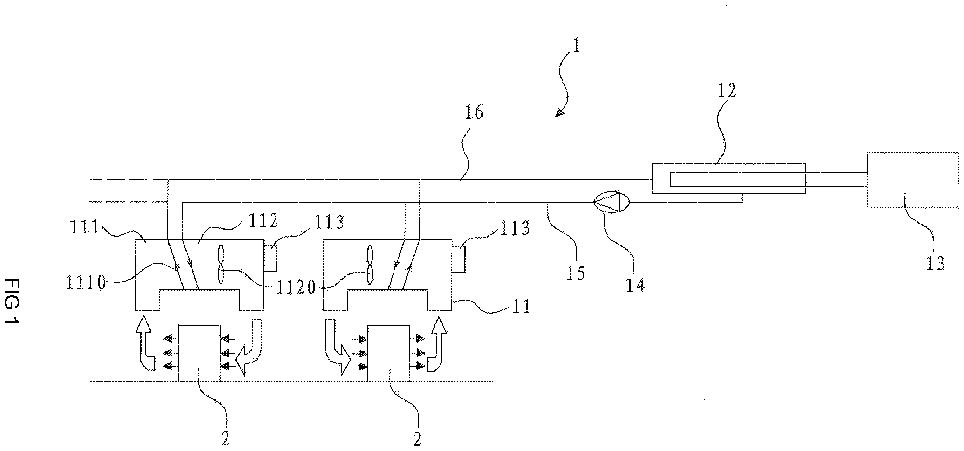

Fig. 1 is a schematic structural view showing the components of an embodiment of the hybrid refrigerant circulating cooling system according to the present invention.

### DETAILED DESCRIPTION OF THE INVENTION

Firstly, it should be noted that, design principles, characteristics and advantages of the hybrid refrigerant circulating cooling system according to the present invention will be specifically described hereinafter by way of example. However, all of the descriptions are made for illustration purpose only, and should not be construed as limitations thereto in any way. In addition, among any individual technical features (or their equivalents) described or implied in each embodiment set forth herein, or illustrated or implied in attached figures, combinations may further be made in any way to obtain more other embodiments that may not have been mentioned directly herein.

In this specification, the term "artificial synthesized refrigerant" refers to a refrigerant that is artificially synthesized, e.g., HFC (hydrofluorocarbons). The term "natural refrigerant" is used relative to a refrigerant that is artificially synthesized, which refers to a material that naturally exists and can be used as a refrigerant, including but not limited to carbon dioxide (known as CO₂, or R744), ammonia gas, propylene, propane, butane and the like. Under certain circumstances, it is possible that such natural refrigerants are termed as environment protective refrigerant, environmentally friendly refrigerant or green refrigerant etc.

In this specification, the term "data processing device" refers to various devices such as computer, server, work station, gateway, stored program control exchanger or communication base station, which perform various data processing such as data access, storage and computing. "Data processing center" refers to a site which is equipped with the above "data processing device", such as various data storage centers, network service centers, data transfer centers, and mobile exchange centers.

Reference is now made to Fig. 1, which schematically illustrates basic constitute parts of an embodiment of the present hybrid refrigerant circulating cooling system. The hybrid refrigerant circulating cooling system 1 mainly comprises an air conditioner terminal device 11, a cooling device composed of a condenser 12 and a cooling water supplier 13, a pumping device 14 and refrigerant conduits 15, 16, etc.

The air conditioner terminal device 11 is one of the important components of the hybrid refrigerant circulating cooling system 1. As shown in Fig. 1, the air conditioner terminal device 11 mainly comprises a heat exchanging section 111 and a blower section 112 which are assembled together in a removable manner. In this manner, not only the assembly of components and daily services and maintenances can be performed very conveniently and flexibly, but also the replacement cost for some components of the system which are damaged or unserviceable, is considerably reduced.

When in use, the air conditioner terminal device 11 is disposed adjacent to the object 2 to be cooled (e.g., computer rack). Generally, the air conditioner terminal device 11 is disposed above the object 2 to be cooled. Alternatively, the air conditioner terminal device 11 can be disposed at other appropriate locations as required by specific applications. Meanwhile, an inlet end and an outlet end of a heat exchanger 1110 disposed in the heat exchange section 111 are connected to the refrigerant conduits 15 and 16 respectively, so as to form a circulation circuit in which fluid flows. Thus, the refrigerant filled in the above refrigerant conduits can circulate around in the circuit so as to conduct heat contact with the outside.

Optionally, a blower 1120 installed in the blower section 112 is under the control of a controller 113. In a specific application, the controller 113 can perform a desired process control over the blower 1120 of the blower section 112 in a variable frequency manner. Under the control of the controller 113, the blower 1120 will convey the working airstream along the direction indicated by the arrows in Fig. 1 in such a way that following the sequence shown in the figure: the working airstream will firstly come into heat contact with the object 2 to be cooled so as to perform heat dissipation and cooling operation thereon, and then come into heat contact with the refrigerant flowing in the heat exchanger 1110 to lower the temperature of the working airstream. Meanwhile, the refrigerant flowing into the heat exchanger 1110 via the inlet end thereof (i.e., the joint of the heat exchanger 1110 and the refrigerant conduit 15) in a liquid phase will evaporate after absorbing heat so as to form into a mixed phase in which the gas phase and the liquid phase co-exist, or into a gas phase at the outlet end (i.e., the joint of the heat exchanger 1110 and the refrigerant conduit 16) of the heat exchanger 1110, and eventually flow into the refrigerant conduit 16. During the above process, if carbon dioxide is selected as the refrigerant, the operating temperature thereof may be controlled to be at 5-30°C, and the operating pressure can be controlled to be at 39-72 bar, which may be achieved by the above-mentioned controller 113 or an additionally provided control component. Since an oil-free refrigerant is used, heat resistance of the heat exchanger can be reduced during phase transition heat exchange, so that the amount of above-mentioned heat contact is made large and the efficiency is higher, and an idle heat exchange effect is achieved.

After the above heat contact process has been completed, it is required to perform cooling treatment on the refrigerant flowing into the refrigerant conduit 16, which is fulfilled by the cooling device of the present hybrid refrigerant circulating cooling system 1. The refrigerant, which is in a gas-liquid two-phase or in a gas phase after absorbing heat due to the heat contact, is cooled into a liquid phase by means of the cooling device. In the embodiment shown in Fig. 1, an implementation of the above cooling device is given in a schematic block diagram. The following description is given with reference to this implementation. However, it should be understood that there are many more other ways that can be chosen to realize the functions of the cooling device.

Specifically, as shown in Fig. 1, the cooling device comprises a condenser 12 and a cooling water supplier 13, wherein the cooling water supplier 13 is arranged to store water and perform cooling treatment on the water, after which the cooling water is supplied to the condenser 12. With respect to the condenser 12, it uses the cooling water supplied from the cooling water supplier 13 to make heat contact with the above described refrigerant which is in a gas-liquid two-phase or in a gas phase after absorbing heat, thus absorbing the heat energy released by the refrigerant. Therefore, by arranging the above described condenser 12 and cooling water supplier 13, a second cooling circulating circuit of the present invention is formed. By means of this second cooling circulating circuit, the heat from the environment in which the object 2 to be cooled is located can be removed continuously. As a result, the stability and consistency of the temperature of the operating environment in which the object 2 to be cooled is located are effectively ensured against the otherwise potential considerable heat generated by the object 2, which is even more significant in applications of the aforesaid high power, high heat density loads.

The pumping device 14 disposed in the refrigerant conduit 15 is also shown in Fig.1. The pumping device 14 pumps the refrigerant which is already in a liquid phase after being cooled, into the heat exchange section 111, thus enabling circulating flowing of the refrigerant in the whole refrigerant conduits.

It should be understood that in the embodiment shown in Fig. 1, the components of the present hybrid refrigerant circulating cooling system are substantially described by way of example only, and more modifications or adjustments can be made according to the actual situation. For example, Fig. 1 shows that two air conditioner terminal devices 11 are provided. However, it is obviously that more air conditioner terminal devices 11 may be provided according to certain applications. Moreover, in order to prevent the adjacent working airstreams from needlessly consuming energy and influencing cooling effect due to interfering movements in reverse directions, the following arrangement can be further employed. That is, the respective blowers 1120 of the adjacent air conditioner terminal devices 11 can be arranged in such a way that the working airstreams formed by them have flow paths in which the directions of flow are opposite, as indicated clearly by various arrows shown in Fig. 1.

In addition, when the air conditioner terminal device 11 is disposed above the object 2 to be cooled, the flow path of the working airstream may be configured in a substantial U shape in the present hybrid refrigerant circulating cooling system 1. That is, an optimal air flow channel is formed to be perpendicular to the inflow and outflow air, so as to enhance cooling effect and save energy consumption.

Correspondingly, a hybrid liquid circulating refrigerant cooling method is also provided herein, comprising the following steps:
step 1. filling an oil-free refrigerant in a refrigerant conduit;
step 2. disposing the above air conditioner terminal device which is configured according to the present invention adjacent to an object to be cooled (e.g., disposing the air conditioner terminal device above the object to be cooled, or at other appropriate locations);
step 3. cooling the refrigerant in the refrigerant conduit, which is in a gas-liquid two-phase or in a gas phase after absorbing heat due to heat contact with the heat exchanger in the air conditioner terminal device, into a liquid phase; and
step 4. pumping the refrigerant in the refrigerant conduit which has been cooled into a liquid phase, into the heat exchanger so as to form a refrigerating circulating circuit.

On the basis of the previous description of the present hybrid refrigerant circulating cooling system, the above hybrid refrigerant circulating cooling method can also be modified or adjusted accordingly. For example, a plurality of air conditioner terminal devices can be provided at the step 2, and can be arranged so that the working airstreams formed by the respective blowers in the adjacent air conditioner terminal devices have flow paths in which the directions of flow are opposite. Moreover, optionally, the flow paths of these working airstreams can be configured in a substantial U shape. Furthermore, in the above hybrid refrigerant circulating cooling method, a controller which is associated with the blower can also be provided for performing control over the operation status of the blower.

According to the above disclosure of the present invention, the hybrid refrigerant circulating cooling system according to the present invention can be freely and flexibly disposed in a data processing center as required by specific applications, so as to perform a spot cooling on one or more data processing devices one by one in the data processing center.

For more details about the air conditioner terminal device described herein such as the structure, configuration and features, please refer to the application entitled "Air Conditioner Terminal Device, Air Conditioning Apparatus and Data Center", which is filed by the applicant on the same day as the present application.

Several specific embodiments are exemplified above in order to explain the hybrid refrigerant circulating cooling system and the data processing center of the present invention. These specific embodiments are intended to explain the principle and the implementation of this invention but not to limit it. The terminology used herein is also for the purpose of describing particular embodiments only and is not intended to limit the present invention. As used herein, the singular forms "a", "an", and "the" are intended to include the plural forms as well, unless the context clearly indicates otherwise. Those skilled in the art can make various modifications and improvements without departing the scope of the present invention. For example, in some situations, the aforesaid controller 113 can be omitted; or, it is not necessary to configure the air conditioner terminal device 11 to include a heat exchange section and a blower section which are assembled in a removable manner; or, the heat exchanger 1110 in the heat exchange section 111 may directly employ a coil structure or any other appropriate structure. Therefore, all equivalents shall be covered by the appended claims

## Claims

1. A hybrid refrigerant circulating cooling system (1) comprising:
a refrigerant conduit (15, 16) in which refrigerant is disposed;
an air conditioner terminal device (11) which is disposed adjacent to an object (2) to be cooled and comprises a heat exchanger (1110) and a blower (1120), wherein the heat exchanger (1110) communicates with the refrigerant conduit (15, 16) to form a circuit, and the refrigerant flows into the heat exchanger (1110) in a liquid phase and flows out of the heat exchanger (1110) in a gas-liquid two-phase or in a gas phase, and the blower (1120) conveys a working airstream which sequentially contacts with the object (2) to be cooled and the heat exchanger (1110);
a cooling device which is disposed downstream of the heat exchanger (1110) along the direction in which the refrigerant flows, wherein the refrigerant in the refrigerant conduit (15, 16) downstream of the cooling device is in a liquid phase; and
a pumping device which is disposed downstream of the cooling device to pump the refrigerant in a liquid phase into the heat exchanger (1110);
**characterized in that** the air conditioner terminal device (11) is disposed above the object (2) to be cooled, and the flow path of the working airstream is configured in a substantial U shape such that the working airstream exits from the air conditioner terminal device (11) in a basically vertical direction, enters, passes and leaves the object (2) to be cooled in a basically horizontal direction and enters into the air conditioner terminal device (11) in a basically vertical direction.

2. The hybrid refrigerant circulating cooling system (1) according to claim 1, wherein the hybrid refrigerant circulating cooling system (1) is provided with at least two air conditioner terminal devices (11), and the working airstreams formed by the respective blowers (1120) in the adjacent air conditioner terminal devices (11) have flow paths in which the directions of flow are opposite.

3. The hybrid refrigerant circulating cooling system (1) according to any of claims 1-2, wherein the air conditioner terminal device (11) is configured to have a heat exchanging section (111) and a blower section (112) which can be assembled together in a removable manner, and wherein the heat exchanger (1110) and the blower (1120) are disposed in the heat exchanging section (111) and the blower section (112), respectively.

4. The hybrid refrigerant circulating cooling system (1) according to any of claims 1-3, wherein the air conditioner terminal device (11) further comprises a controller (113) which is associated with the blower (1120).

5. The hybrid refrigerant circulating cooling system (1) according to any of claims 1-3, wherein the cooling device comprises:
a condenser (12) which, by means of cooling water, absorbs heat energy released by the refrigerant; and
a cooling water supplier (13) which serves to store water and supply it to the condenser (12) after the water is cooled.

6. The hybrid refrigerant circulating cooling system (1) according to any of claims 1-3, wherein the refrigerant is an oil-free refrigerant, including carbon dioxide and HFC.

7. The hybrid refrigerant circulating cooling system (1) according to any of claims 1-3, wherein the object (2) to be cooled is the rack of data processing device.

8. A data processing center comprising at least one data processing device, **characterized in that** a hybrid refrigerant circulating cooling system (1) according to any of claims 1-7 is disposed in the data processing center to perform cooling treatment.

## Patentansprüche

1. Hybridkältemittel zirkulierendes Kühlsystem (1), umfassend:
eine Kältemittelleitung (15, 16), in der Kältemittel angeordnet ist;
ein Klimaanlagen-Endgerät (11), das neben einem zu kühlenden Objekt (2) angeordnet ist und einen Wärmetauscher (1110) und ein Gebläse (1120) umfasst, wobei der Wärmetauscher (1110) mit der Kältemittelleitung (15, 16) kommuniziert, um einen Kreislauf zu bilden, und das Kältemittel in einer Flüssigkeitsphase in den Wärmetauscher (1110) fließt und in einer Gas-Flüssigkeits-Bi-Phase oder in einer Gasphase aus dem Wärmetauscher (1110) fließt und das Gebläse (1120) einen Arbeitsluftstrom überträgt, der der Reihe nach das zu kühlende Objekt (2) und den Wärmetauscher (1110) kontaktiert;
eine Kühlvorrichtung, die dem Wärmetauscher (1110) in der Richtung, in der das Kältemittel fließt, nachgelagert angeordnet ist, wobei das Kältemittel in der Kältemittelleitung (15, 16) stromabwärts der Kühlvorrichtung in einer Flüssigkeitsphase ist; und
eine Pumpvorrichtung, die stromabwärts der Kühlvorrichtung angeordnet ist, um das Kältemittel in einer Flüssigkeitsphase in den Wärmetauscher (1110) zu pumpen;
**dadurch gekennzeichnet, dass** das Klimaanlagen-Endgerät (11) über dem zu kühlenden Objekt (2) angeordnet ist und der Fließweg des Arbeitsluftstroms im Wesentlichen U-förmig konfiguriert ist, sodass der Arbeitsluftstrom in einer grundlegend vertikalen Richtung aus dem Klimaanlagen-Endgerät (11) austritt, in einer grundlegend horizontalen Richtung in das zu kühlende Objekt (2) eintritt, dieses durchläuft und verlässt und in einer grundlegend vertikalen Richtung in das Klimaanlagen-Endgerät (11) eintritt.

2. Hybridkältemittel zirkulierendes Kühlsystem (1) nach Anspruch 1, wobei das Hybridkältemittel zirkulierende Kühlsystem (1) mit mindestens zwei Klimaanlagen-Endgeräten (11) ausgestattet ist und die Arbeitsluftströme, die von den entsprechenden Gebläsen (1120) in den angrenzenden Klimaanlagen-Endgeräten (11) gebildet werden, Fließwege aufweisen, in denen die Fließrichtungen entgegengesetzt sind.

3. Hybridkältemittel zirkulierendes Kühlsystem (1) nach einem der Ansprüche 1-2, wobei das Klimaanlagen-Endgerät (11) dazu konfiguriert ist, einen Wärmetauscherabschnitt (111) und einen Gebläseabschnitt (112) aufzuweisen, die zusammen auf abnehmbare Weise montiert werden können, und wobei der Wärmetauscher (1110) und das Gebläse (1120) im Wärmetauscherabschnitt (111) bzw. im Gebläseabschnitt (112) angeordnet sind.

4. Hybridkältemittel zirkulierendes Kühlsystem (1) nach einem der Ansprüche 1-3, wobei das Klimaanlagen-Endgerät (11) ferner ein Steuergerät (113) umfasst, das mit dem Gebläse (1120) verbunden ist.

5. Hybridkältemittel zirkulierendes Kühlsystem (1) nach einem der Ansprüche 1-3, wobei die Kühlvorrichtung Folgendes umfasst:
einen Kondensator (12), der mittels Kühlwasser die Wärmeenergie, die vom Kältemittel freigesetzt wird, absorbiert; und
eine Kühlwasserversorgungsvorrichtung (13), die dem Speichern von Wasser und dem Zuführen von Wasser zu dem Kondensator (12), nachdem das Wasser gekühlt worden ist, dient.

6. Hybridkältemittel zirkulierendes Kühlsystem (1) nach einem der Ansprüche 1-3, wobei das Kältemittel ein ölfreies Kältemittel ist, das Kohlendioxid und H-FKW beinhaltet.

7. Hybridkältemittel zirkulierendes Kühlsystem (1) nach einem der Ansprüche 1-3, wobei das zu kühlende Objekt (2) das Gestell einer Datenverarbeitungsvorrichtung ist.

8. Datenverarbeitungszentrum, umfassend mindestens eine Datenverarbeitungsvorrichtung, **dadurch gekennzeichnet, dass** ein Hybridkältemittel zirkulierendes Kühlsystem (1) nach einem der Ansprüche 1-7 im Datenverarbeitungszentrum angeordnet ist, um eine Kühlbehandlung durchzuführen.

## Revendications

1. Système de refroidissement à circulation de réfrigérant hybride (1) comprenant :
un conduit de réfrigérant (15, 16) dans lequel le réfrigérant est déposé ;
un dispositif terminal de climatiseur (11) qui est disposé à côté d'un objet (2) à refroidir et qui comprend un échangeur de chaleur (1110) et un ventilateur (1120), dans lequel l'échangeur de chaleur (1110) communique avec le conduit de réfrigérant (15, 16) pour former un circuit, et le réfrigérant s'écoule dans l'échangeur de chaleur (1110) en phase liquide et sort de l'échangeur de chaleur (1110) dans un état biphasé gaz-liquide ou en phase gazeuse, et le ventilateur (1120) achemine un flux d'air de travail qui entre en contact de manière séquentielle avec l'objet (2) à refroidir et l'échangeur de chaleur (1110) ;
un dispositif de refroidissement qui est disposé en aval de l'échangeur de chaleur (1110) le long de la direction d'écoulement du réfrigérant, dans lequel le réfrigérant dans le conduit de réfrigérant (15, 16) en aval du dispositif de refroidissement est en phase liquide ; et
un dispositif de pompage qui est disposé en aval du dispositif de refroidissement pour pomper le réfrigérant en phase liquide dans l'échangeur de chaleur (1110) ;
**caractérisé en ce que** le dispositif terminal de climatiseur (11) est disposé au-dessus de l'objet (2) à refroidir, et le trajet d'écoulement du flux d'air de travail est configuré en une forme sensiblement en U de sorte que le flux d'air de travail sort du dispositif terminal de climatiseur (11) dans une direction essentiellement verticale, entre, passe et quitte l'objet (2) à refroidir dans une direction essentiellement horizontale et entre dans le dispositif terminal de climatiseur (11) dans une direction essentiellement verticale.

2. Système de refroidissement à circulation de réfrigérant hybride (1) selon la revendication 1, dans lequel le système de refroidissement à circulation de réfrigérant hybride (1) est doté d'au moins deux dispositifs terminaux de climatiseur (11), et les flux d'air de travail formés par les ventilateurs respectifs (1120) dans les dispositifs terminaux de climatiseur adjacents (11) ont des trajets d'écoulement dont les directions d'écoulement sont opposées.

3. Système de refroidissement à circulation de réfrigérant hybride (1) selon l'une quelconque des revendications 1 à 2, dans lequel le dispositif terminal de climatiseur (11) est configuré pour être doté d'une section d'échange de chaleur (111) et d'une section de ventilateur (112) qui peuvent être assemblées ensemble de manière amovible, et dans lequel l'échangeur de chaleur (1110) et le ventilateur (1120) sont disposés dans la section d'échange de chaleur (111) et la section de ventilateur (112), respectivement.

4. Système de refroidissement à circulation de réfrigérant hybride (1) selon l'une quelconque des revendications 1 à 3, dans lequel le dispositif terminal de climatiseur (11) comprend en outre un dispositif de commande (113) qui est associé au ventilateur (1120).

5. Système de refroidissement à circulation de réfrigérant hybride (1) selon l'une quelconque des revendications 1 à 3, dans lequel le dispositif de refroidissement comprend :
un condenseur (12) qui, au moyen d'eau de refroidissement, absorbe l'énergie thermique libérée par le réfrigérant ; et
un fournisseur d'eau de refroidissement (13) qui sert à stocker l'eau et à l'acheminer jusqu'au condenseur (12) après refroidissement de l'eau.

6. Système de refroidissement à circulation de réfrigérant hybride (1) selon l'une quelconque des revendications 1 à 3, dans lequel le réfrigérant est un réfrigérant sans huile, comportant du dioxyde de carbone et du HFC.

7. Système de refroidissement à circulation de réfrigérant hybride (1) selon l'une quelconque des revendications 1 à 3, dans lequel l'objet (2) à refroidir est le bâti d'un dispositif de traitement de données.

8. Centre de traitement de données comprenant au moins un dispositif de traitement de données, **caractérisé en ce qu'**un système de refroidissement à circulation de réfrigérant hybride (1) selon l'une quelconque des revendications 1 à 7 est disposé dans le centre de traitement de données pour effectuer un traitement de refroidissement.
